# FASCICULE DE BREVET EUROPEEN

(11) **EP 4 148 919 B1**
(45) Date de publication et mention de la délivrance du brevet: **19.07.2023**
(21) Numéro de dépôt: 22195108.0
(22) Date de dépôt: 12.09.2022
(51) Int. Cl.: H01S 5/02, H01S 5/026, H01S 5/10, H01S 5/227

(54) **PROCEDE DE FABRICATION D'UNE DIODE SEMICONDUCTRICE PAR GRAVURES SECHE ET HUMIDE**
VERFAHREN ZUR HERSTELLUNG EINER HALBLEITERDIODE DURCH TROCKEN- UND NASSÄTZUNG
METHOD FOR MANUFACTURING A SEMICONDUCTOR DIODE BY DRY AND WET ETCHING

(30) Priorité: 14.09.2021 FR 2109625
(43) Date de publication de la demande: 15.03.2023
(73) Titulaire: Commissariat à l'énergie atomique et aux énergies alternatives, 75015 Paris (FR)
(72) Inventeur: SZELAG, Bertrand, 38054 GRENOBLE Cedex 9 (FR); ADELMINI, Laetitia, 38054 GRENOBLE Cedex 9 (FR)
(74) Mandataire: Brevalex

(56) Documents cités:
- WO-A1-2013/189949
- FR-A1- 3 107 998
- SZELAG BERTRAND ET AL: "Hybrid III-V/Silicon Technology for Laser Integration on a 200-mm Fully CMOS-Compatible Silicon Photonics Platform", IEEE JOURNAL OF SELECTED TOPICS IN QUANTUM ELECTRONICS, IEEE, USA, vol. 25, no. 5, 1 septembre 2019 (2019-09-01), pages 1-10, XP011736125, ISSN: 1077-260X, DOI: 10.1109/JSTQE.2019.2904445 [extrait le 2019-07-24]

## Description

### DOMAINE TECHNIQUE

Le domaine de l'invention est celui des procédés de fabrication des diodes semiconductrices tels que les diodes émissives (diodes laser et diodes électroluminescentes) ou les photodiodes. L'invention trouve une application en particulier dans le cadre de la photonique sur silicium et de la fabrication de sources laser hybrides.

### ÉTAT DE LA TECHNIQUE ANTÉRIEURE

La fabrication de diodes semiconductrices telles que les diodes émissives et les photodiodes peut nécessiter de structurer un plot semiconducteur par des opérations de gravures sèches et de gravures humides. Or, il est connu que ces techniques de gravure peuvent impliquer des sur-gravures parasites qui dégradent les dimensions latérales et/ou verticales souhaitées du plot semiconducteur, se traduisant alors par un impact négatif sur les performances de la diode semiconductrice. En effet, la gravure chimique peut induire une dégradation des matériaux non protégés, et notamment une gravure latérale non souhaitée (*undercut* en anglais) lorsque les flancs d'une couche d'un matériau sensible à l'agent de gravure ne sont pas protégés. De plus, la gravure sèche peut présenter une inhomogénéité, dans le plan du substrat support, de la profondeur de gravure, pouvant conduire à une gravure verticale non souhaitée.

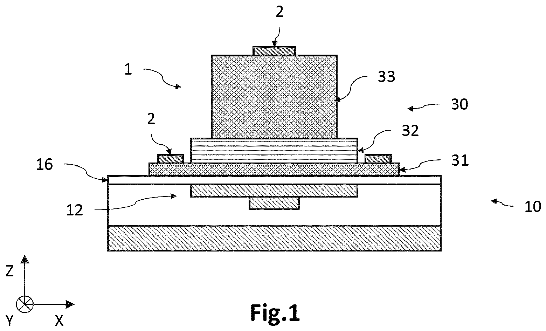

Cette problématique est particulièrement présente dans le domaine de la photonique sur silicium et de la réalisation des sources laser hybrides. A ce titre, le document FR3107998 présente un exemple de procédé de fabrication d'une diode laser hybride 1 mettant en oeuvre des étapes de gravure sèche et de gravure humide. Comme l'illustre la figure 1, la diode laser 1 comporte un plot semiconducteur 30 formant un guide d'onde dit actif contenant le milieu à gain, qui repose sur un substrat fonctionnalisé 10 de type silicium sur isolant (SOI pour *Silicon-On-Insulator,* en anglais) dans lequel est situé un circuit photonique intégré. Ce dernier comporte un guide d'onde 12 en silicium couplé optiquement au guide d'onde actif. La diode laser hybride 1 et le circuit photonique intégré forment ensemble une puce photonique.

Ce plot semiconducteur 30 (guide d'onde actif) est formé d'un empilement de portions de couches minces réalisées à base d'un composé III-V, parmi lesquelles : une portion supérieure 33 dopée p, une portion active 32 comportant des couches de confinement et une couche active intercalaire contenant des puits quantiques, et une portion inférieure 31 dopée n. Celle-ci présente une largeur supérieure à celle des portions du dessus, de manière à pouvoir être contactée par des métallisations 2 participant à la polarisation électrique du guide d'onde actif de la diode laser 1.

Ainsi, après le report d'une vignette III-V sur le substrat fonctionnalisé, le guide d'onde actif est réalisé en mettant en oeuvre une étape de gravure sèche pour former la portion supérieure 33 dopée p et une partie de la portion active 32, cette gravure sèche s'arrêtant dans une couche inférieure de confinement pour ne pas risquer d'entamer la couche inférieure dopée n (au risque d'augmenter la résistance d'accès associée à la portion inférieure 31 dopée n de la diode laser 1). Puis, une étape de gravure humide est effectuée pour supprimer la partie résiduelle de la couche inférieure de confinement et ainsi rendre libre une surface supérieure de la couche inférieure dopée n. Cependant, lors de cette étape, il y a un risque de gravure latérale non souhaitée (*undercut*) de la portion active 32, ce qui peut conduire à une dégradation des performances de la diode laser 1.

Le document "Hybrid III-V/Silicon Technology for Laser Intégration on a 200-mm Fully CMOS-Compatible Silicon Photonics Platform" (IEEE JOURNAL OF SELECTED TOPICS IN QUANTUM ELECTRONICS, IEEE, USA, ISSN 1077-260X) par SZELAG BERTRAND ET AL décrit un procédé de fabrication d'une diode semi-conductrice évanescente hybride sur silicium par double gravure sèche et humide dans lequel dans lequel la réalisation d'un plot semiconducteur comporte les étapes suivantes : dépôt d'un premier masque dur sur une couche supérieure; gravure sèche de la couche supérieure pour former une portion supérieure, sans arrêt de gravure sur la couche active, une portion latérale de la couche supérieure étant non entièrement gravée et formant une portion résiduelle reposant sur une couche inférieure; dépôt et structuration d'un masque dur de manière à former une portion de masque dur encapsulant la portion supérieure et laissant libre une surface supérieure de la couche inférieure et donc une partie de la portion résiduelle; gravure humide de la portion résiduelle de manière sélective, de manière à rendre libre une surface non recouverte par un premier espaceur.

### EXPOSÉ DE L'INVENTION

L'invention a pour objectif de remédier au moins en partie aux inconvénients de l'art antérieur, et plus particulièrement de proposer un procédé de fabrication d'une diode semiconductrice dont le plot semiconducteur présente les dimensions souhaitées, de manière à limiter les risques de dégradation des performances attendues de la diode semiconductrice à la suite du procédé de fabrication.

Pour cela, l'objet de l'invention est un procédé de fabrication d'une diode semiconductrice comportant les étapes suivantes : report d'un empilement semiconducteur sur un substrat support, comportant, à partir du substrat support : une couche inférieure dopée selon un premier type de conductivité ; une couche active comportant au moins un puits quantique ; une couche supérieure dopée selon un deuxième type de conductivité opposé au premier type ; et réalisation, par gravure localisée de l'empilement semiconducteur, d'un plot semiconducteur comportant une portion inférieure dopée ; une portion active présentant une dimension latérale inférieure à celle de la portion inférieure ; et une portion supérieure dopée présentant une dimension latérale inférieure à celle de la portion active.

Selon l'invention, la réalisation du plot semiconducteur comporte les étapes suivantes :
- dépôt d'un premier masque dur sur la couche supérieure ;
- gravure sèche de la couche supérieure pour former la portion supérieure, avec arrêt de gravure sur la couche active, une portion latérale de la couche supérieure étant non entièrement gravée et formant une première portion résiduelle reposant sur la couche active ;

- dépôt et structuration d'un deuxième masque dur de manière à former une première portion de masque dur, appelée premier espaceur, encapsulant la portion supérieure et laissant libre une surface supérieure de la couche active et donc une partie de la première portion résiduelle ;
- gravure humide de la première portion résiduelle de manière sélective vis-à-vis de la couche active, de manière à rendre libre une surface de la couche active non recouverte par le premier espaceur ;
- gravure sèche de la couche active pour former la portion active, avec arrêt de gravure sur la couche inférieure, une portion latérale de la couche active étant non entièrement gravée et formant une deuxième portion résiduelle reposant sur la couche inférieure ;
- dépôt et structuration d'un troisième masque dur de manière à former une deuxième portion de masque dur, appelée deuxième espaceur, entourant latéralement le premier espaceur et la portion active, et laissant libre une surface supérieure de la couche inférieure et donc une partie de la deuxième portion résiduelle ;
- gravure humide de la deuxième portion résiduelle de manière sélective vis-à-vis de la couche inférieure, de manière à rendre libre une surface de la couche inférieure non recouverte par le deuxième espaceur.

Certains aspects préférés mais non limitatifs de ce procédé de fabrication sont les suivants.

Le deuxième masque dur et le troisième masque dur peuvent présenter, avant leur structuration, une épaisseur inférieure à celle de l'empilement semiconducteur avant l'étape de gravure sèche de la couche supérieure.

Le procédé peut comporter une étape de gravure localisée de la partie de la couche inférieure non recouverte par le deuxième espaceur pour former la portion inférieure.

Les premier, deuxième et troisième masques dur peuvent être réalisés à base d'un nitrure de silicium.

Le deuxième et troisième masque dur peuvent être réalisés en un nitrure de silicium, ou sont formés en un bicouche comportant d'une première sous-couche de nitrure de silicium et d'une deuxième sous-couche en un oxyde ou en un silane.

Le plot semiconducteur peut être réalisé à base d'un composé III-V, d'un composé II-VI, ou d'un élément ou composé IV.

Le plot semiconducteur peut être réalisé à base d'un composé III-V, et le substrat support peut être un substrat de type silicium sur isolant SOI.

La diode semiconductrice peut être une diode laser hybride dont le plot semiconducteur forme un guide d'onde couplé optiquement avec un guide d'onde intégré situé dans le substrat support.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1, déjà décrite, est une vue schématique et partielle, en coupe, d'une source laser hybride d'une puce photonique selon un exemple de l'art antérieur ;
les figures 2A à 2J illustrent différentes étapes d'un procédé de fabrication d'une diode semiconductrice selon un mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'une diode semiconductrice par structuration d'un plot semiconducteur au moyen de différentes étapes de gravure sèche et de gravure humide, de sorte que le plot semiconducteur présente *in fine* les dimensions verticales et latérales voulues.

Dans le cadre de l'invention, le plot semiconducteur est formé d'un empilement de portions de couches semiconductrices reposant sur un substrat support. Il comporte, à partir du substrat support, une portion inférieure dopée selon un premier type de conductivité, par exemple de type n, une portion active comportant au moins un puits quantique, et une portion supérieure dopée selon un deuxième type de conductivité opposé au premier type, par exemple de type p.

De plus, le plot semiconducteur présente des dimensions latérales telles que, d'une part, la portion inférieure dopée présente une dimension latérale supérieure à celles de la portion active et de la portion supérieure dopée, et que d'autre part, la portion active présente une dimension latérale supérieure à celles de la portion supérieure dopée. La portion inférieure dopée est donc plus large que les portions du dessus de manière à permettre une prise de contact électrique latéral.

Par ailleurs, rappelons qu'une gravure sèche (*dry etching,* en anglais) est une gravure essentiellement physique qui présente un caractère fortement anisotrope. Elle peut consister en un bombardement par des ions de la surface libre d'un matériau, c'est-à-dire une surface non protégée par un masque de gravure (appelé masque dur). Il peut s'agir d'une gravure ionique réactive (RIE, pour *Reactive Ion Etching,* en anglais), éventuellement de type ICP (*Inductively Coupled Plasma,* en anglais). Par ailleurs, une gravure humide (*wet etching,* en anglais) est une gravure chimique par laquelle un composant (en partie protégé) est introduit dans une solution qui va attaquer chimiquement la surface libre (non protégée) du composant. Ce type de gravure est fortement isotrope et présente une bonne sélectivité des matériaux.

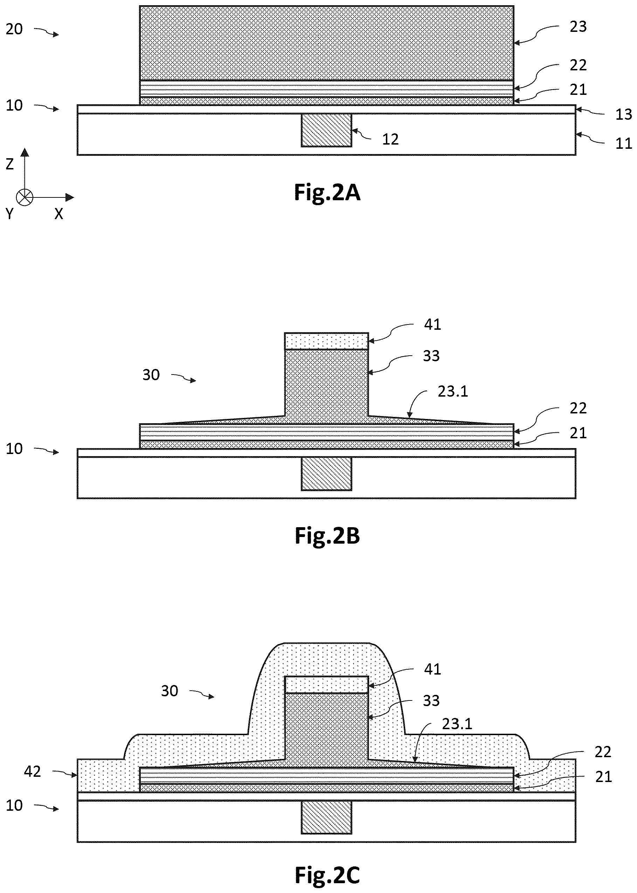

Les figures 2A à 2J illustrent différentes étapes d'un procédé de fabrication d'une diode semiconductrice 1 selon un mode de réalisation. Comme indiqué précédemment, la diode semiconductrice 1 peut être une diode émissive telle qu'une diode laser ou une diode électroluminescente, ou peut être une photodiode.

Dans cet exemple, la diode semiconductrice 1 est une diode laser hybride d'une puce photonique. Une puce photonique est un dispositif optoélectronique comportant au moins une diode laser hybride 1 reposant sur le substrat fonctionnalisé 10 et couplé optiquement à un guide d'onde intégré situé dans le substrat fonctionnalisé 10. Ce guide d'onde intégré forme une partie d'un circuit photonique intégré.

La diode semiconductrice 1 est, d'une manière générale, réalisée à base d'un composé semiconducteur III-V (par exemple InP, GaAs, GaN...), II-VI (par exemple CdTe, HgTe, CdHgTe...), ou d'un élément ou composé IV (par exemple Ge, SiGe, GeSn...), c'est-à-dire qu'il comporte majoritairement le composé semiconducteur en question. Elle est une hétérostructure formée d'une portion 31 de couche dopée n, d'une portion 33 de couche dopée p, et d'une portion 32 de couche active intercalaire contenant au moins un puits quantique. Dans cet exemple, elle est réalisée à base d'un composé III-V, ici à base d'InP, et le substrat fonctionnalisé 10 est un substrat de type SOI.

On définit ici et pour la suite de la description un repère direct tridimensionnel orthogonal XYZ, où le plan XY est un plan parallèle au plan du substrat fonctionnalisé 10, et où l'axe Z est orienté du substrat fonctionnalisé 10 vers la diode laser 1. Par ailleurs, les termes « inférieur » et « supérieur » s'entendent comme étant relatifs à un positionnement croissant lorsqu'on s'éloigne du substrat fonctionnalisé 10 suivant la direction +Z.

En référence à la fig.2A, on reporte un empilement semiconducteur 20 sur le substrat fonctionnalisé 10. Le substrat fonctionnalisé 10 est ici de type SOI, et comporte un substrat support réalisée par exemple en silicium (non représenté) et présentant une épaisseur de l'ordre de plusieurs centaines de microns, une couche d'oxyde enterré (BOX, pour *Buried Oxide,* en anglais) qui recouvre le substrat support, et un guide d'onde intégré 12. Le guide d'onde intégré 12 est formé ici en silicium monocristallin, et est entouré par un oxyde 11 formé un gain de bas indice de réfraction. Dans cet exemple, il est revêtu d'une couche diélectrique de collage 13, ici réalisée en un oxyde de silicium, qui définit la face supérieure du substrat fonctionnalisé 10. Elle présente une épaisseur de l'ordre de quelques dizaines de nanomètres, par exemple une épaisseur comprise entre 20nm et 100nm environ. Dans cet exemple, le guide d'onde intégré 12 est un guide droit, mais en variante, il peut être un guide en arête formé d'une base (*slab*) et d'une arête (*rib*)*.*

L'empilement semiconducteur 20 prend ici la forme d'une vignette, c'est-à-dire d'une partie d'une plaque (*wafer* en anglais), mais en variante il peut être une plaque entière. L'empilement semiconducteur 20 est formé ici d'une couche inférieure 21 dopée selon un premier type de conductivité, ici de l'InP dopé n d'une épaisseur de 150nm environ, d'une couche active 22 d'une épaisseur de 300nm environ formée d'une sous-couche inférieure de confinement en InGaAsP, d'une sous-couche comportant des puits quantiques en InGaAsP/InAsP, d'une sous-couche supérieure de confinement en InGaAsP, et enfin d'une couche supérieure 23 dopée selon un deuxième type de conductivité opposé au premier type, ici de l'InP dopé p d'une épaisseur de 2µm environ, éventuellement recouverte d'une couche de InGaAs dopé p (non représentée) d'une épaisseur de 300nm destinée à améliorer le contact électrique. Les couches de confinement présentent un indice de réfraction choisi pour améliorer le confinement du mode optique guidé dans la sous-couche à puits quantique (milieu à gain). Par ailleurs, l'empilement semiconducteur 20 peut comporter également le substrat de croissance en InP (non représenté).

L'empilement semiconducteur 20 est ainsi reportée sur le substrat fonctionnalisé 10, et est fixée à celui-ci par collage direct par exemple de type oxyde/oxyde. Ensuite, on supprime le substrat de croissance, par exemple par gravure humide à l'acide chlorhydrique éventuellement précédée par un amincissement mécanique, de manière à rendre libre la face supérieure de la couche supérieure 23 dopée p.

En référence à la fig.2B, on structure la couche supérieure 23 dopée p par gravure sèche, de manière à former une portion supérieure 33 dopée p. Pour cela, on dépose un masque dur 41 sur une surface de la couche supérieure 23 dopée p destinée à former le plot semiconducteur 30 de la diode laser 1, le masque dur 41 étant par exemple réalisé en un nitrure de silicium d'une épaisseur comprise entre 400nm et 800nm déposé par dépôt chimique en phase vapeur assisté par plasma (PECVD). Ensuite, on réalise une gravure sèche, de manière à graver localement la couche supérieure 23 dopée p dans les zones non protégées et à former la portion supérieure 33 dopée p, avec arrêt de gravure sur la couche active 22 (notons que le substrat fonctionnalisé 10 est protégé de la gravure sèche). L'arrêt de la gravure peut notamment être effectué par détection de fin d'attaque, c'est-à-dire lorsque du matériau InGaAsP de la couche active 22 est détecté. La couche supérieure 23 dopée p est ainsi supprimée, hormis la portion 33 recouverte par le masque dur 41. Celui-ci est ici avantageusement conservé.

Comme mentionné précédemment, la technique de gravure sèche peut présenter une inhomogénéité dans le plan XY de la profondeur de gravure, de sorte que du matériau InP de la couche supérieure 23 dopée p à graver peut rester. Ainsi, à la suite de la gravure sèche, le plot semiconducteur 30 présente une portion supérieure 33 ayant sensiblement la même dimension latérale que celle du masque dur 41, et une portion résiduelle latérale 23.1, non gravée, qui repose sur la couche active 22. Cette portion résiduelle 23.1 est représentée ici de manière schématique comme une portion s'étendant à partir de la portion supérieure 33 dopée p et dont l'épaisseur diminue à mesure que l'on s'en éloigne, mais elle peut dans les faits se présenter différemment. Quoi qu'il en soit, le procédé selon l'invention adresse également les variations d'épaisseur de la portion résiduelle au niveau intra-plaque, par exemple du centre de la plaque à sa bordure), comme au niveau d'une plaque à l'autre (lorsque par exemple le procédé est mis en oeuvre sur plusieurs plaques en parallèle).

Cette portion résiduelle 23.1 peut présenter une épaisseur maximale de l'ordre de 115nm, ce qui correspond à une inhomogénéité de la profondeur de gravure de l'ordre de 5% de l'épaisseur initiale à graver, soit ici 2300nm formés de l'épaisseur cumulée de la couche supérieure 23 dopée p et de la couche supérieure de contact. Notons que cette inhomogénéité étant alors de l'ordre de la moitié de l'épaisseur de la couche active 22, ce qui justifie de ne pas chercher à supprimer cette portion résiduelle 23.1 lors de la gravure sèche au risque que cette légère gravure verticale non souhaitée conduise à dégrader la couche active 22 sous-jacente.

Aussi, selon l'invention, on choisit de structurer les couches 21, 22, 23 de l'empilement semiconducteur 20 par gravure sèche plutôt que par gravure humide de manière à bénéficier d'un meilleur contrôle des dimensions latérales, sans chercher à supprimer les portions résiduelles latérales pour éviter toute gravure verticale non souhaitée des couches sous-jacentes. Puis on supprime localement les portions résiduelles par gravure humide, de manière à obtenir une bonne uniformité d'épaisseur des portions de couches obtenues.

En référence à la fig.2C, on dépose une couche de masque dur 42 de manière à recouvrir continûment la portion supérieure 33 dopée p, la portion résiduelle 23.1, la couche active 22 et la couche inférieure 21 dopée n, ainsi que le substrat fonctionnalisé 10. Il s'agit d'un masque dur dans la mesure où une gravure sèche sera mise en oeuvre ultérieurement, par exemple un nitrure de silicium d'une épaisseur comprise entre 600nm et 2µm déposé par PECVD. L'épaisseur de la couche de masque dur 42 est choisie pour être inférieure à l'épaisseur totale du plot semiconducteur 30 en cours de réalisation. En variante, la couche de masque dur 42 peut être un bicouche formé d'une première sous-couche de SiN par exemple de l'ordre de 200nm et d'une deuxième sous-couche d'un orthosilicate de tétraéthyle (TEOS) ou d'un silane de l'ordre de 800nm.

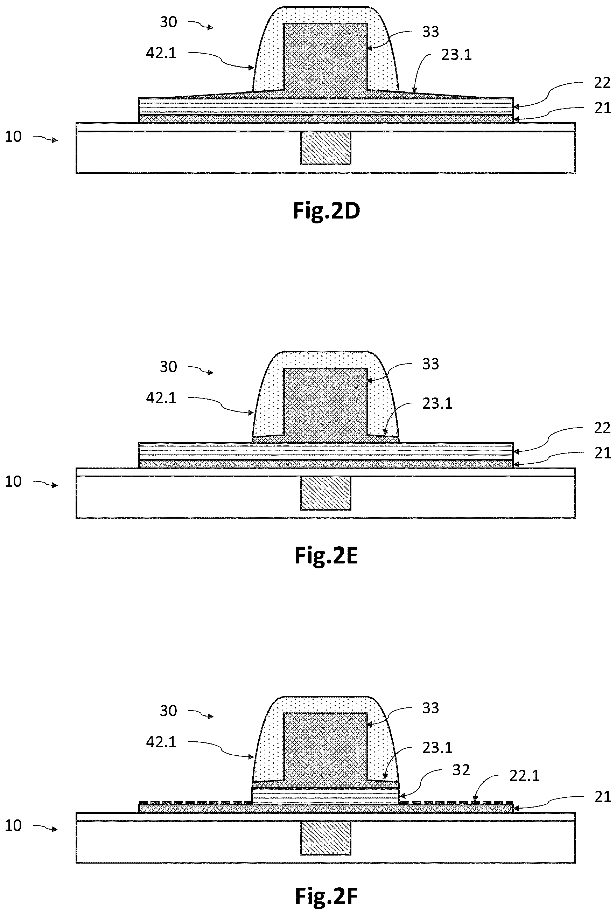

En référence à la fig.2D, on structure ensuite la couche de masque dur 42 pour former une portion de masque dur 42.1, appelée premier espaceur, encapsulant la portion supérieure 33 dopée p seulement. Elle s'étend donc sur la face supérieure et sur les flancs de la portion supérieure 33 dopée p, et recouvre une partie seulement de la portion résiduelle 23.1 et donc également de la couche active 22. Une autre partie de la portion résiduelle 23.1 présente une surface libre (non recouverte). Cette étape peut être effectuée par une gravure sèche de la couche de masque dur 42, avec arrêt par détection de fin d'attaque lorsqu'on détecte de l'oxyde du substrat fonctionnalisé 10 et/ou de l'InGaAsP de la couche active 22. L'espaceur 42.1 est donc de préférence obtenu par un dépôt conforme de la couche de masque dur 42, présentant une épaisseur inférieure à celle de la portion supérieure 33, suivi d'une structuration par gravure anisotropique.

En référence à la fig.2E, on effectue une gravure humide d'une partie de la portion résiduelle 23.1, celle non protégée par l'espaceur 42.1, de manière à rendre libre la surface de la couche active 22 non recouverte par l'espaceur 42.1. Cette gravure humide est sélective vis-à-vis de l'espaceur 42.1, de la couche active 22 et de la couche inférieure 21 dopée n. Ainsi, à la suite de cette étape, la couche active 22 présente une surface libérée de tout matériau résiduel 23.1 de la couche supérieure 23 dopée p. Cette étape de gravure humide remplace la sur-gravure verticale qui n'a volontairement pas été effectuée lors de l'étape de la fig.2B pour éviter de dégrader la couche active 22. Cette gravure humide peut être effectuée avec une solution à base d'HCl qui est notamment sélectif vis-à-vis de l'InGaAsP de la couche active 22. Par ailleurs, l'InP dopé p est protégé de l'agent de gravure par l'espaceur 42.1. On obtient ainsi une couche active 22 libérée du matériau résiduel 23.1, de sorte que l'on peut maintenant effectuer une nouvelle étape de gravure sèche.

En référence à la fig.2F, on structure la couche active 22 par gravure sèche, de manière à former une portion active 32 dont la face supérieure est recouverte par la portion supérieure 33 dopée p. Ainsi, on grave localement la couche active 22 dans les zones non protégées par l'espaceur 42.1, avec arrêt de gravure sur la couche inférieure 21 dopée n. L'arrêt de la gravure est effectué par détection de fin d'attaque lorsque du matériau InP de la couche inférieure 21 dopée n est détecté. Une partie de la couche active 22 est ainsi supprimée, hormis la partie protégée par l'espaceur 42.1.

Comme précédemment, du fait de l'inhomogénéité de la profondeur de gravure de la gravure sèche mise en oeuvre, il reste une portion résiduelle latérale 22.1 du matériau InGaAsP de la couche active 22 sur la couche inférieure 21 dopée n. Dans cet exemple, cette portion résiduelle 22.1 non gravée de la couche active 22 est représentée par les traits en pointillés du fait de sa faible épaisseur, ici de l'ordre de 15nm (5% de 300nm). De manière volontaire, on choisit de ne pas effectuer une sur-gravure verticale lors de la gravure sèche qui serait destinée à supprimer cette portion résiduelle 22.1, pour éviter toute dégradation de la couche inférieure 21 dopée n (ce qui impacterait négativement la résistance d'accès associée à cette couche inférieure 21).

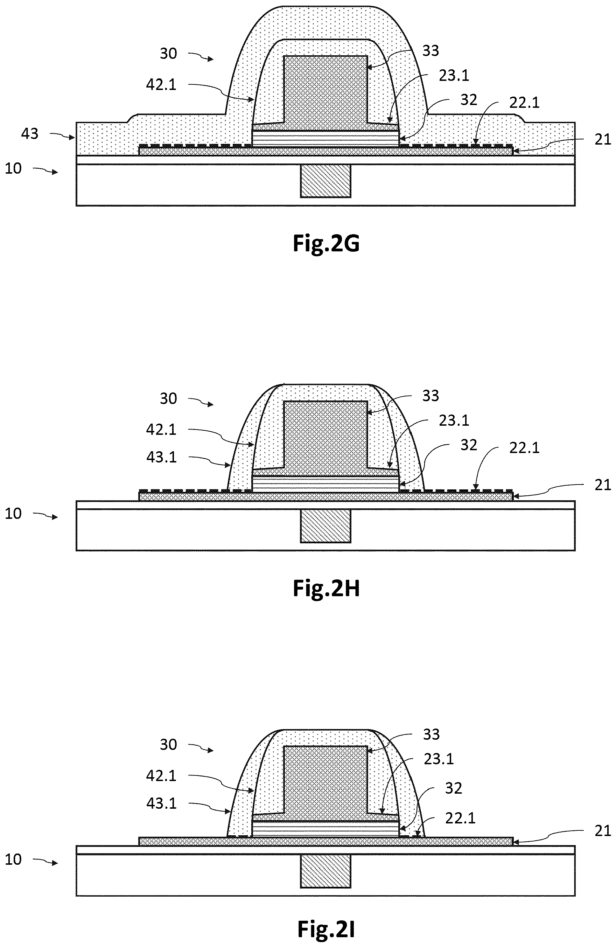

En référence à la fig.2G, on dépose une deuxième couche 43 de masque dur de manière à recouvrir continûment l'espaceur 42.1, la portion résiduelle 22.1, la couche active 22 et la couche inférieure 21 dopée n. Il s'agit d'un masque dur dans la mesure où une deuxième étape de gravure sèche sera mise en oeuvre ultérieurement. Il peut être réalisé en un nitrure de silicium d'une épaisseur comprise entre 600nm et 2µm déposé par PECVD. L'épaisseur de la couche de masque dur 43 est choisie ici aussi pour être inférieure à l'épaisseur totale du plot semiconducteur 30 en cours de réalisation. En variante, la couche de masque dur 43 peut être un bicouche formé d'une première sous-couche de SiN et d'une deuxième sous-couche d'un orthosilicate de tétraéthyle (TEOS) ou d'un silane.

En référence à la fig.2H, on structure ensuite la deuxième couche 43 de masque dur pour former une deuxième portion de masque dur 43.1, appelée deuxième espaceur, entourant latéralement l'espaceur 42.1. Elle s'étend donc au moins sur les flancs de l'espaceur 42.1, et recouvre une partie de la portion résiduelle 22.1 de la couche active 22. Une autre partie de la portion résiduelle 22.1 de la couche active 22 présente une surface libre (non recouverte), et la couche inférieure 21 dopée n présente également une surface libre (au moins la surface latérale). Cette étape peut être effectuée par une gravure sèche de la couche de masque dur 43, avec arrêt par détection de fin d'attaque lorsqu'on détecte de l'oxyde du substrat fonctionnalisé 10 et/ou de l'InP de la couche inférieure 21 dopée n. L'espaceur 43.1 est donc de préférence obtenu par un dépôt conforme de la couche de masque dur 43, présentant une épaisseur inférieure à l'épaisseur cumulée des portions 32 et 33, suivi d'une structuration par gravure anisotropique.

En référence à la fig.2I, on effectue une gravure humide d'une partie de la portion résiduelle 22.1 (celle non recouverte par l'espaceur 43.1), de manière à rendre libre la surface de la couche inférieure 21 dopée n non recouverte par l'espaceur 43.1. Cette gravure humide est sélective vis-à-vis de la couche inférieure 21 dopée n, et vis-à-vis des espaceurs 42.1 et 43.1. Ainsi, à la suite de cette étape, la couche inférieure 21 dopée n présente une surface libérée de tout matériau résiduel 22.1 de la couche active 22. Comme précédemment, cette étape de gravure humide remplace la sur-gravure verticale qui n'a volontairement pas été effectuée lors de l'étape de la fig.2F pour éviter de dégrader la couche inférieure 21 dopée n.

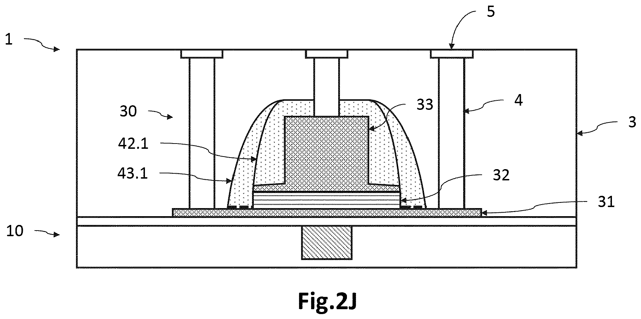

En référence à la fig.2J, on finalise la fabrication de la diode laser 1. Pour cela, on structure la couche inférieure 21 dopée n de manière à obtenir une portion inférieure 31 dopée n présentant une dimension latérale supérieure à celle des portions du dessus 32 et 33. Une couche isolante d'encapsulation 3 est déposée de manière à recouvrir entièrement le plot semiconducteur 30 et les espaceurs 42.1 et 43.1. Des vias conducteurs 4 sont réalisés qui s'étendent au travers de la couche d'encapsulation 3 jusqu'à venir contacter la portion inférieure 31 dopée n et la portion supérieure 33 dopée p. Notons que des métallisations de contact (non représentées) peuvent avoir été réalisées au préalable (comme sur la fig.1), sur les portions inférieure 31 et supérieure 33, de manière à améliorer le contact électrique avec les vias conducteurs 4. Enfin, des plots de contact 5 peuvent être réalisés à la surface de la couche d'encapsulation 3.

Ainsi, on obtient une diode laser 1 dont le plot semiconducteur 30 présente les dimensions verticale et latérale souhaitées, ce qui contribue à préserver les performances de la diode laser 1. Comme indiqué précédemment, le procédé de fabrication met en oeuvre des étapes de gravure sèche pour structurer l'empilement semiconducteur 20 et obtenir le plot semiconducteur 30 ayant les dimensions souhaitées. On évite toute gravure verticale non souhaitée qui pourrait dégrader les couches sous-jacentes, ce qui conduit à former des portions résiduelles latérales non gravées 22.1 et 23.1. Celles-ci sont supprimées par gravure humide, avant de procéder à la gravure sèche suivante.

Des modes de réalisation particuliers viennent d'être décrits. Différentes variantes et modifications apparaîtront à l'homme du métier, notamment dans le cas où la diode semiconductrice est une diode électroluminescente ou est une photodiode.

## Revendications

1. Procédé de fabrication d'une diode semiconductrice (1) comportant les étapes suivantes :
∘ report d'un empilement semiconducteur (20) sur un substrat support (10), comportant, à partir du substrat support (10) : une couche inférieure (21) dopée selon un premier type de conductivité ; une couche active (22) comportant au moins un puits quantique ; une couche supérieure (23) dopée selon un deuxième type de conductivité opposé au premier type ;
∘ réalisation, par gravure localisée de l'empilement semiconducteur (20), d'un plot semiconducteur (30) comportant une portion inférieure (31) dopée ; une portion active (32) présentant une dimension latérale inférieure à celle de la portion inférieure (31) ; et une portion supérieure (33) dopée présentant une dimension latérale inférieure à celle de la portion active (32), cette étape comportant les étapes suivantes :
• dépôt d'un premier masque dur (41) sur la couche supérieure (23) ;
• gravure sèche de la couche supérieure (23) pour former la portion supérieure (33),
• dépôt et structuration d'un deuxième masque dur (42) de manière à former une première portion de masque dur (42.1), appelée premier espaceur, encapsulant la portion supérieure (33) et laissant libre une surface supérieure de la couche active (22) ;
∘ dans lequel :
• l'étape de gravure sèche de la couche supérieure (23) est effectuée avec arrêt de gravure sur la couche active (22), une portion latérale de la couche supérieure (23) étant non entièrement gravée et formant une première portion résiduelle (23.1) reposant sur la couche active (22) ;
• lors de la formation du premier espaceur (42.1), une partie de la première portion résiduelle (23.1) est également laissée libre ;
∘ et en ce que la réalisation du plot semiconducteur (30) comporte les étapes suivantes :
• gravure humide de la première portion résiduelle (23.1) de manière sélective vis-à-vis de la couche active (22), de manière à rendre libre une surface de la couche active (22) non recouverte par le premier espaceur (42.1) ;
• gravure sèche de la couche active (22) pour former la portion active (32), avec arrêt de gravure sur la couche inférieure (21), une portion latérale de la couche active (22) étant non entièrement gravée et formant une deuxième portion résiduelle (22.1) reposant sur la couche inférieure (21) ;
• dépôt et structuration d'un troisième masque dur (43) de manière à former une deuxième portion de masque dur (43.1), appelée deuxième espaceur, entourant latéralement le premier espaceur (42.1) et la portion active (32), et laissant libre une surface supérieure de la couche inférieure (21) et donc une partie de la deuxième portion résiduelle (22.1) ;
• gravure humide de la deuxième portion résiduelle (22.1) de manière sélective vis-à-vis de la couche inférieure (21), de manière à rendre libre une surface de la couche inférieure (21) non recouverte par le deuxième espaceur (43.1).

2. Procédé de fabrication selon la revendication 1, dans lequel le deuxième masque dur (42) et le troisième masque dur (43) présentent, avant leur structuration, une épaisseur inférieure à celle de l'empilement semiconducteur (20) avant l'étape de gravure sèche de la couche supérieure (23).

3. Procédé de fabrication selon la revendication 1 ou 2, comportant une étape de gravure localisée de la partie de la couche inférieure (21) non recouverte par le deuxième espaceur (43.1) pour former la portion inférieure (31).

4. Procédé de fabrication selon l'une quelconque des revendications 1 à 3, dans lequel les premier, deuxième et troisième masques dur (41, 42, 43) sont réalisés à base d'un nitrure de silicium.

5. Procédé de fabrication selon l'une quelconque des revendications 1 à 4, dans lequel le deuxième et troisième masque dur (42, 43) sont réalisés en un nitrure de silicium, ou sont formés en un bicouche comportant d'une première sous-couche de nitrure de silicium et d'une deuxième sous-couche en un oxyde ou en un silane.

6. Procédé de fabrication selon l'une quelconque des revendications 1 à 5, dans lequel le plot semiconducteur (30) est réalisé à base d'un composé III-V, d'un composé II-VI, ou d'un élément ou composé IV.

7. Procédé de fabrication selon l'une quelconque des revendications 1 à 6, dans lequel le plot semiconducteur (30) est réalisé à base d'un composé III-V, et le substrat support (10) est un substrat de type silicium sur isolant SOI.

8. Procédé de fabrication selon l'une quelconque des revendications 1 à 7, dans lequel la diode semiconductrice (1) est une diode laser hybride dont le plot semiconducteur (30) forme un guide d'onde couplé optiquement avec un guide d'onde intégré (12) situé dans le substrat support (10).

## Patentansprüche

1. Herstellungsverfahren einer Halbleiterdiode (1), die folgenden Schritte beinhaltend:
∘ Übertragen eines Halbleiterstapels (20) auf ein Trägersubstrat (10), der vom Trägersubstrat (10) ausgehend beinhaltet: eine untere Schicht (21), die gemäß einem ersten Leitfähigkeitstyp dotiert ist; eine aktive Schicht (22), die mindestens einen Quantentopf beinhaltet; eine obere Schicht (23), die mit einem zweiten Leitfähigkeitstyp dotiert ist, der dem ersten Leitfähigkeitstyp entgegengesetzt ist;
∘ Realisieren, durch lokalisiertes Ätzen des Halbleiterstapels (20), eines Halbleiterpads (30), das einen dotierten unteren Abschnitt (31) beinhaltet, einen aktiven Abschnitt (32), der eine seitliche Abmessung aufweist, die kleiner als diejenige des unteren Abschnitts (31) ist, und einen dotierten oberen Abschnitt (33), der eine seitliche Abmessung aufweist, die kleiner als diejenige des aktiven Abschnitts (32) ist, wobei dieser Schritt die folgenden Schritte beinhaltet:
• Abscheiden einer ersten Hartmaske (41) auf der oberen Schicht (23);
• Trockenätzen der oberen Schicht (23), um den oberen Abschnitt (33) zu bilden;
• Abscheiden und Strukturieren einer zweiten Hartmaske (42), um einen ersten Abschnitt der Hartmaske (42.1) zu bilden, erster Abstandshalter genannt, der den oberen Abschnitt (33) einkapselt und eine obere Oberfläche der aktiven Schicht (22) frei lässt;
∘ wobei:
• der Schritt der Trockenätzung der oberen Schicht (23) mit Ätzsperrung auf der aktiven Schicht (22) erfolgt, wobei ein seitlicher Abschnitt der oberen Schicht (23) nicht vollständig geätzt ist und einen ersten Restabschnitt (23.1) bildet, der auf der aktiven Schicht (22) ruht;
• bei der Bildung des ersten Abstandshalters (42.1) ein Bereich des ersten Restabschnitts (23.1) ebenfalls frei bleibt;
∘ und dass die Realisierung des Halbleiterpads (30) die folgenden Schritte beinhaltet:
• Nassätzen des ersten Restabschnitts (23.1) selektiv in Bezug auf die aktive Schicht (22), um eine Oberfläche der aktiven Schicht (22) frei zu machen, die nicht vom ersten Abstandshalter (42.1) bedeckt ist;
• Trockenätzen der aktiven Schicht (22), um den aktiven Abschnitt (32) zu bilden, mit Ätzsperrung auf der unteren Schicht (21), wobei ein seitlicher Abschnitt der aktiven Schicht (22) nicht vollständig geätzt ist und einen zweiten Restabschnitt (22.1) bildet, der auf der unteren Schicht (21) ruht;
• Abscheiden und Strukturieren einer dritten Hartmaske (43), um einen zweiten Abschnitt der Hartmaske (43.1), zweiter Abstandshalter genannt, zu bilden, der den ersten Abstandshalter (42.1) und den aktiven Abschnitt (32) seitlich umgibt, und eine obere Oberfläche der unteren Schicht (21), und damit einen Bereich des zweiten Restabschnitts (22.1) frei lassend;
• Nassätzen des zweiten Restabschnitts (22.1) selektiv in Bezug auf die untere Schicht (21), um eine Oberfläche der unteren Schicht (21) frei zu machen, die nicht vom zweiten Abstandshalter (43.1) bedeckt ist.

2. Herstellungsverfahren nach Anspruch 1, wobei die zweite Hartmaske (42) und die dritte Hartmaske (43), vor ihrer Strukturierung, eine geringere Dicke aufweisen als die des Halbleiterstapel (20) vor dem Schritt der Trockenätzung der oberen Schicht (23).

3. Herstellungsverfahren nach Anspruch 1 oder 2, einen Schritt der lokalisierten Ätzung des Bereichs der unteren Schicht (21) beinhaltend, der nicht vom zweiten Abstandshalter (43.1) bedeckt ist, um den unteren Abschnitt (31) zu bilden.

4. Herstellungsverfahren nach einem der Ansprüche 1 bis 3, wobei die erste, zweite und dritte Hartmaske (41, 42, 43) auf der Basis eines Siliciumnitrids realisiert sind.

5. Herstellungsverfahren nach einem der Ansprüche 1 bis 4, wobei die zweite und dritte Hartmaske (42, 43) aus Siliciumnitrid realisiert sind oder aus einer Doppelschicht gebildet sind, die eine erste Unterschicht aus Siliciumnitrid beinhaltet und eine zweite Unterschicht aus Oxid oder Silan.

6. Herstellungsverfahren nach einem der Ansprüche 1 bis 5, wobei das Halbleiterpad (30) auf der Basis einer III-V-Verbindung, einer II-VI-Verbindung oder eines IV-Elements oder -Verbindung realisiert ist.

7. Herstellungsverfahren nach einem der Ansprüche 1 bis 6, wobei das Halbleiterpad (30) auf der Basis einer III-V-Verbindung realisiert ist und das Trägersubstrat (10) vom Typ Silicium auf einem Isolator SOI ist.

8. Herstellungsverfahren nach einem der Ansprüche 1 bis 7, wobei die Halbleiterdiode (1) ein Hybrid-Diodenlaser ist, dessen Halbleiterpad (30) einen Wellenleiter bildet, der mit einem integrierten Wellenleiter (12), der sich im Trägersubstrat (10) befindet, optisch gekoppelt ist.

## Claims

1. Method for manufacturing a semiconductor diode (1) including the following steps:
∘ adding a semiconductor stack (20) onto a support substrate (10), including, starting from the support substrate (10): a lower layer (21) doped according to a first type of conductivity; an active layer (22) including at least one quantum well; an upper layer (23) doped according to a second type of conductivity opposite to the first type;
∘ creating, by localised etching of the semiconductor stack (20), a semiconductor contact (30) including a doped lower portion (31); an active portion (32) having a lateral dimension smaller than that of the lower portion (31); and a doped upper portion (33) having a lateral dimension smaller than that of the active portion (32), this step including the following steps:
• depositing a first hard mask (41) on the upper layer (23);
• dry etching of the upper layer (23) to form the upper portion (33),
• depositing and structuring a second hard mask (42) so as to form a first portion of hard mask (42.1), called first spacer, encapsulating the upper portion (33) and leaving free an upper surface of the active layer (22);
∘ wherein:
• the step of dry etching of the upper layer (23) is carried out with stoppage of the etching on the active layer (22), a lateral portion of the upper layer (23) being not entirely etched and forming a first residual portion (23.1) resting on the active layer (22);
• during the formation of the first spacer (42.1), a part of the first residual portion (23.1) is also left free;
∘ and in that the creation of the semiconductor contact (30) includes the following steps:
• wet etching of the first residual portion (23.1) selectively with respect to the active layer (22), so as to make free a surface of the active layer (22) not covered by the first spacer (42.1);
• dry etching of the active layer (22) to form the active layer (32), with stoppage of the etching on the lower layer (21), a lateral portion of the active layer (22) being not entirely etched and forming a second residual portion (22.1) resting on the lower layer (21);
• depositing and structuring a third hard mask (43) so as to form a second portion of hard mask (43.1), called second spacer, laterally surrounding the first spacer (42.1) and the active portion (32), and leaving free an upper surface of the lower layer (21) and thus a part of the second residual portion (22.1);
• wet etching of the second residual portion (22.1) selectively with respect to the lower layer (21), so as to make free a surface of the lower layer (21) not covered by the second spacer (43.1).

2. Manufacturing method according to claim 1, wherein the second hard mask (42) and the third hard mask (43) have, before their structuring, a thickness smaller than that of the semiconductor stack (20) before the step of dry etching of the upper layer (23).

3. Manufacturing method according to claim 1 or 2, including a step of localised etching of the part of the lower layer (21) not covered by the second spacer (43.1) to form the lower portion (31).

4. Manufacturing method according to any one of claims 1 to 3, wherein the first, second and third hard mask (41, 42, 43) are made using a silicon nitride.

5. Manufacturing method according to any one of claims 1 to 4, wherein the second and third hard mask (42, 43) are made of a silicon nitride, or are formed from a bilayer including a first sublayer of silicon nitride and a second sublayer made of an oxide or made of a silane.

6. Manufacturing method according to any one of claims 1 to 5, wherein the semiconductor contact (30) is made using a III-V compound, a II-VI compound, or a IV element or compound.

7. Manufacturing method according to any one of claims 1 to 6, wherein the semiconductor contact (30) is made using a III-V compound, and the support substrate (10) is a substrate of the SOI silicon on insulator type.

8. Manufacturing method according to any one of claims 1 to 7, wherein the semiconductor diode (1) is a hybrid laser diode, the semiconductor contact (30) of which forms a waveguide optically coupled with an integrated waveguide (12) located in the support substrate (10).
